# EUROPEAN PATENT SPECIFICATION

(11) **EP 3 554 740 B1**
(45) Date of publication and mention of the grant of the patent: **02.03.2022**
(21) Application number: 17794557.3
(22) Date of filing: 23.10.2017
(51) Int. Cl.: B22C 9/02, B22C 9/10, B22C 13/08, B22C 13/12, B22D 29/00, B28B 1/00, G03F 7/00, G03F 7/20, B29C 64/124, B29C 64/135, B29C 64/129, B22C 7/02, B22C 9/04, B22C 9/22, B33Y 10/00, B33Y 80/00

(54) **A METHOD FOR FABRICATING A CERAMIC CASTING MOLD**
VERFAHREN ZUR HERSTELLUNG EINER KERAMIKGUSSFORM
PROCEDE DE FABRICATION D'UN MOULE DE COULEE EN CERAMIQUE

(30) Priority: 13.12.2016 US 201615377673
(43) Date of publication of application: 23.10.2019
(73) Proprietor: General Electric Company, Schenectady, NY 12345 (US)
(72) Inventor: MCCARREN, Michael, John, Cincinnati, OH 45215 (US); DEINES, James Herbert, Cincinnati, OH 45215 (US); YANG, Xi, West Chester, OH 45209 (US); PRZESLAWSKI, Brian David, Liberty Township, Ohio 45044 (US)
(74) Representative: Hafner & Kohl PartmbB
(86) International application number: PCT/US2017/057831
(87) International publication number: WO 2018/111404

(56) References cited:
- EP-A1- 3 290 186
- US-A- 5 370 499
- US-A- 6 117 612
- US-A1- 2008 006 384
- US-A1- 2008 080 979
- US-A1- 2010 003 619
- US-A1- 2010 028 645
- US-A1- 2016 221 262
- US-B2- 8 851 151
- Prepared By ET AL: "3D PRINTING OF HOLLOW COMPOUNDS", , 1 December 2015 (2015-12-01), pages 18-21, XP055436872, Retrieved from the Internet: URL:http://esatjournals.net/ijret/2015v04/ i12/IJRET20150412004.pdf [retrieved on 2017-12-20]

## Description

The present disclosure generally relates to investment casting core-shell mold components and processes utilizing these components. The core-shell mold made in accordance with the present invention includes integrated hollow ceramic core tubes that are used to define at least a portion of an interior region of a cast article. In the case of a turbine blade, the tubes may define the inner core region, and/or may define a portion of a ceramic core filament for producing a cooling hole in the turbine blade. The use of sufficient ceramic filaments between core and shell to both locate and provide leaching pathways for the core serpentine also enables the elimination of ball braze chutes. Ceramic filaments between the tip plenum core and the shell may also be provided to support a floating tip plenum, eliminating the need for traditional tip pins, and their subsequent closure by brazing. The integrated core-shell molds provide useful properties in casting operations, such as in the casting of superalloys used to make turbine blades and stator vanes for jet aircraft engines or power generation turbine components.

### BACKGROUND

Many modern engines and next generation turbine engines require components and parts having intricate and complex geometries, which require new types of materials and manufacturing techniques. Conventional techniques for manufacturing engine parts and components involve the laborious process of investment or lost-wax casting. One example of investment casting involves the manufacture of a typical rotor blade used in a gas turbine engine. A turbine blade typically includes hollow airfoils that have radial channels extending along the span of a blade having at least one or more inlets for receiving pressurized cooling air during operation in the engine. The various cooling passages in a blade typically include a serpentine channel disposed in the middle of the airfoil between the leading and trailing edges. The airfoil typically includes inlets extending through the blade for receiving pressurized cooling air, which include local features such as short turbulator ribs or pins for increasing the heat transfer between the heated sidewalls of the airfoil and the internal cooling air.

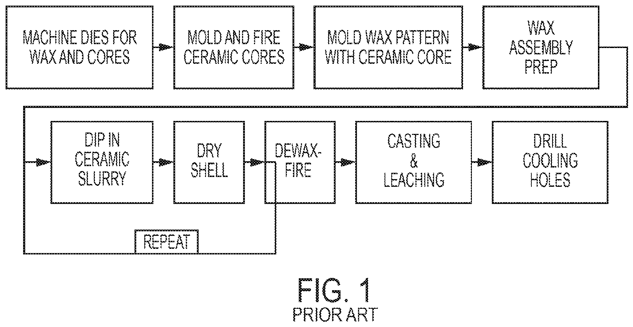

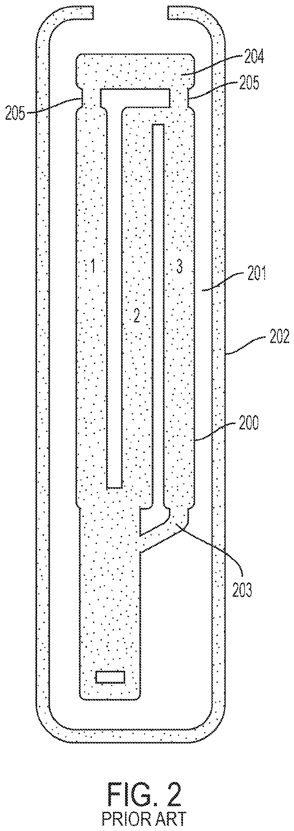

The manufacture of these turbine blades, typically from high strength, superalloy metal materials, involves numerous steps shown in FIG. 1. First, a precision ceramic core is manufactured to conform to the intricate cooling passages desired inside the turbine blade. A precision die or mold is also created which defines the precise 3-D external surface of the turbine blade including its airfoil, platform, and integral dovetail. A schematic view of such a mold structure is shown in FIG. 2. The ceramic core 200 is assembled inside two die halves which form a space or void therebetween that defines the resulting metal portions of the blade. Wax is injected into the assembled dies to fill the void and surround the ceramic core encapsulated therein. The two die halves are split apart and removed from the molded wax. The molded wax has the precise configuration of the desired blade and is then coated with a ceramic material to form a surrounding ceramic shell 202. Then, the wax is melted and removed from the shell 202 leaving a corresponding void or space 201 between the ceramic shell 202 and the internal ceramic core 200 and tip plenum 204. Molten superalloy metal is then poured into the shell to fill the void therein and again encapsulate the ceramic core 200 and tip plenum 204 contained in the shell 202. The molten metal is cooled and solidifies, and then the external shell 202 and internal core 200 and tip plenum 204 are suitably removed leaving behind the desired metallic turbine blade in which the internal cooling passages are found. In order to provide a pathway for removing ceramic core material via a leaching process, a ball chute 203 and tip pins 205 are provided, which upon leaching form a ball chute and tip holes within the turbine blade that must subsequently brazed shut.

The cast turbine blade may then undergo additional post-casting modifications, such as but not limited to drilling of suitable rows of film cooling holes through the sidewalls of the airfoil as desired for providing outlets for the internally channeled cooling air which then forms a protective cooling air film or blanket over the external surface of the airfoil during operation in the gas turbine engine. After the turbine blade is removed from the ceramic mold, the ball chute 203 of the ceramic core 200 forms a passageway that is later brazed shut to provide the desired pathway of air through the internal voids of the cast turbine blade. However, these post-casting modifications are limited and given the ever increasing complexity of turbine engines and the recognized efficiencies of certain cooling circuits inside turbine blades, more complicated and intricate internal geometries are required. While investment casting is capable of manufacturing these parts, positional precision and intricate internal geometries become more complex to manufacture using these conventional manufacturing processes. Accordingly, it is desired to provide an improved casting method for three dimensional components having intricate internal voids.

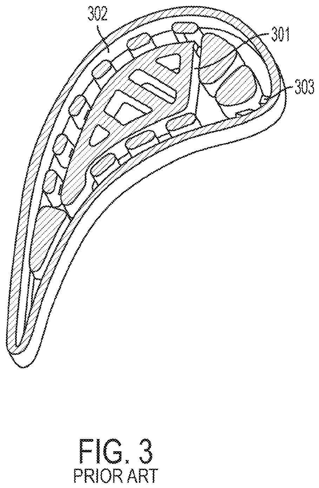

Methods for using 3-D printing to produce a ceramic core-shell mold are described in U.S. Patent No. 8,851,151 assigned to Rolls-Royce Corporation. The methods for making the molds include powder bed ceramic processes such as disclosed U.S. Patent No. 5,387,380 assigned to Massachusetts Institute of Technology, and selective laser activation (SLA) such as disclosed in U.S. Patent No. 5,256,340 assigned to 3D Systems, Inc. The ceramic core-shell molds according to the '151 patent are limited by the printing resolution capabilities of these processes. As shown in FIG. 3, the core portion 301 and shell portion 302 of the integrated core-shell mold is held together via a series of tie structures 303 provided at the bottom edge of the mold. Cooling passages are proposed in the '151 patent that include staggered vertical cavities joined by short cylinders, the length of which is nearly the same as its diameter. A superalloy turbine blade is then formed in the core-shell mold using known techniques disclosed in the '151 patent. After a turbine blade is cast in one of these core-shell molds, the mold is removed to reveal a cast superalloy turbine blade.

There remains a need to prepare ceramic core-shell molds produced using higher resolution methods that are capable of providing fine detail cast features in the end-product of the casting process.

US 2008/080979 discloses an airfoil is disclosed having at least first and second cast, axiallystacked internal airflow cooling circuits.

US 5 370 499 discloses a turbine airfoil has a mesh cooling hole arrangement which includes first and second pluralities of cooling holes extending between internal and external surfaces of an airfoil side wall at least at a pressure side and extending from an internal chamber to the airfoil exterior.

US 2008/006384 discloses an investment casting pattern component has a spine and a number of tines extending from the spine.

US 8 851 151 discloses a system for producing cast components from molten metal.

US 6 117 612 discloses photocurable ceramic resins having solids loadings in excess of 40 volume percent and a viscosity of less than 3000 mPaxs are suitable for multi-layer fabrication of green ceramic parts by stereolithography.

US 2010/0028645 A1 discloses an apparatus comprising a green article having a part defining portion and a firing support portion each of the portions formed of a plurality of layers coupled together by a sacrificial polymer binder, and each of the plurality of layers includes a particulate material held together by the sacrificial polymer binder; and the portions having a similar thermal shrinkage rate.

### SUMMARY

The invention is defined by the appended claims. In a first aspect, the invention relates to a method of making a ceramic casting mold in accordance with claim 1.

In another aspect, the invention relates to a method of preparing a cast component in accordance with claim 5.

In one aspect, the cast component is a turbine blade or stator vane. Preferably the turbine blade or stator vane is used in a gas turbine engine in, for example, an aircraft engine or power generation. The turbine blade or stator vane is preferably a single crystal cast turbine blade or stator vane having a cooling hole pattern defined by the ceramic filaments mentioned above. Preferably, the filaments join the core portion and shell portion where each filament spans between the core and shell, the filaments having a cross sectional area ranging from 0.01 to 2 mm².

The large number of filaments used to form a cooling hole pattern may provide sufficient strength to support the tip core. If the tip filaments are made to support tip plenum core, they may be made larger, i.e., >2 mm cross section area, and a much lower number of filaments, or a single filament, could be used. Although two to four of these larger filaments is a desirable number. After casting, any holes or notches remaining in the tip plenum sidewalls as a result of the filaments may be brazed shut or incorporated into the turbine blade or stator vane design, or the filaments may be placed outside the finish machined shape of the component to prevent the need for this.

### BRIEF DESCRIPTION OF THE DRAWINGS

FIG. 1 is a flow diagram showing the steps for conventional investment casting.
FIG. 2 is a schematic diagram showing an example of a conventional scheme for a core-shell mold with ball chute prepared by a conventional process.
FIG. 3 shows a perspective view of a prior art integrated core-shell mold with ties connecting the core and shell portions.
FIGS. 4, 5, 6 and7 show schematic lateral sectional views of a device for carrying out successive phases of the method sequence for direct light processing (DLP).
FIG. 8 shows a schematic sectional view along the line A-A of FIG. 7.
FIG. 9 shows a side view of an integrated core-shell mold with filaments connecting the core and shell portions.
FIG. 10. show the integrated core-shell mold of FIG. 9 filled with cast metal.
FIG. 11 shows a side view of an integrated core-shell mold according to an embodiment of the present invention.
FIG. 12 shows a side view of a superalloy-filled integrated core-shell mold according to an embodiment of the present invention.
FIG. 13 shows the cast turbine blade made in accordance with the invention.

### DETAILED DESCRIPTION

The detailed description set forth below in connection with the appended drawings is intended as a description of various configurations and is not intended to represent the only configurations in which the concepts described herein may be practiced. The detailed description includes specific details for the purpose of providing a thorough understanding of various concepts. However, it will be apparent to those skilled in the art that these concepts may be practiced without these specific details. For example, the present invention provides a preferred method for making cast metal parts, and preferably those cast metal parts used in the manufacture of jet aircraft engines. Specifically, the production of single crystal, nickel-based superalloy cast parts such as turbine blades, vanes, and shroud components can be advantageously produced in accordance with this invention. However, other cast metal components may be prepared using the techniques and integrated ceramic molds of the present invention.

The present inventors recognized that prior processes known for making integrated core-shell molds lacked the fine resolution capability necessary to print filaments extending between the core and shell portion of the mold of sufficiently small size and quantity to result in effusion cooling holes in the finished turbine blade. In the case of earlier powder bed processes, such as disclosed in U.S. Patent No. 5,387,380 assigned to Massachusetts Institute of Technology, the action of the powder bed recoater arm precludes formation of sufficiently fine filaments extending between the core and shell to provide an effusion cooling hole pattern in the cast part. Other known techniques such as selective laser activation (SLA) such as disclosed in U.S. Patent No. 5,256,340 assigned to 3D Systems, Inc. that employ a top-down irradiation technique may be utilized in producing an integrated core-shell mold in accordance with the present invention. However, the available printing resolution of these systems significantly limit the ability to make filaments of sufficiently small size to serve as effective cooling holes in the cast final product.

The integrated core-shell casting mold of the present invention is manufactured using direct light processing (DLP). DLP differs from the above discussed powder bed and SLA processes in that the light curing of the polymer occurs through a window at the bottom of a resin tank that projects light upon a build platform that is raised as the process is conducted. With DLP an entire layer of cured polymer is produced simultaneously, and the need to scan a pattern using a laser is eliminated. Further, the polymerization occurs between the underlying window and the last cured layer of the object being built. The underlying window provides support allowing thin filaments of material to be produced without the need for a separate support structure. In other words, producing a thin filament of material bridging two portions of the build object is difficult and was typically avoided in the prior art. For example, the ' 151 patent discussed above in the background section of this application used vertical plate structures connected with short cylinders, the length of which was on the order of their diameter. Staggered vertical cavities are necessitated by the fact that the powder bed and SLA techniques disclosed in the '151 patent require vertically supported ceramic structures and the techniques are incapable of reliably producing filaments. In addition, the available resolution within a powder bed is on the order of 1/8" making the production of traditional cooling holes impracticable. For example, round cooling holes generally have a diameter of less than 2 mm corresponding to a cooling hole area below 3.2 mm². Production of a hole of such dimensions requires a resolution far below the size of the actual hole given the need to produce the hole from several voxels. This resolution is simply not available in a powder bed process. Similarly, stereolithography is limited in its ability to produce such filaments due to lack of support and resolution problems associated with laser scattering. But the fact that DLP exposes the entire length of the filament and supports it between the window and the build plate enables producing sufficiently thin filaments spanning the entire length between the core and shell to form a ceramic object having the desired cooling hole pattern. Although powder bed and SLA may be used to produce filaments, their ability to produce sufficiently fine filaments as discussed above is limited.

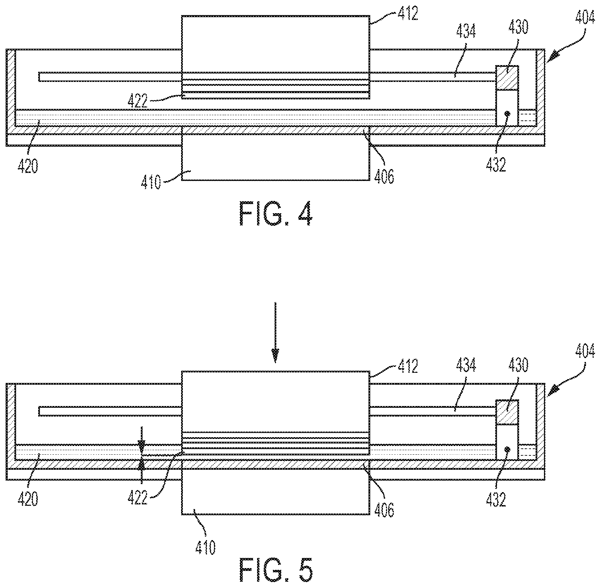

One suitable DLP process is disclosed in U.S. Patent No. 9,079,357 assigned to Ivoclar Vivadent AG and Technische Universitat Wien, as well as WO 2010/045950 A1 and US 2011310370, which are discussed below with reference to FIGS. 4-8. The apparatus includes a tank 404 having at least one translucent bottom portion 406 covering at least a portion of the exposure unit 410. The exposure unit 410 comprises a light source and modulator with which the intensity can be adjusted position-selectively under the control of a control unit, in order to produce an exposure field on the tank bottom 406 with the geometry desired for the layer currently to be formed.

Opposite the exposure unit 410, a production platform 412 is provided above the tank 404; it is supported by a lifting mechanism (not shown) so that it is held in a height-adjustable way over the tank bottom 406 in the region above the exposure unit 410. The production platform 412 may likewise be transparent or translucent in order that light can be shone in by a further exposure unit above the production platform in such a way that, at least when forming the first layer on the lower side of the production platform 412, it can also be exposed from above so that the layer cured first on the production platform adheres thereto with even greater reliability.

The tank 404 contains a filling of highly viscous photopolymerizable material 420. The material level of the filling is much higher than the thickness of the layers which are intended to be defined for position-selective exposure. In order to define a layer of photopolymerizable material, the following procedure is adopted. The production platform 412 is lowered by the lifting mechanism in a controlled way so that (before the first exposure step) its lower side is immersed in the filling of photopolymerizable material 420 and approaches the tank bottom 406 to such an extent that precisely the desired layer thickness Δ (see FIG. 5) remains between the lower side of the production platform 412 and the tank bottom 406. During this immersion process, photopolymerizable material is displaced from the gap between the lower side of the production platform 412 and the tank bottom 406. After the layer thickness Δ has been set, the desired position-selective layer exposure is carried out for this layer, in order to cure it in the desired shape. Particularly when forming the first layer, exposure from above may also take place through the transparent or translucent production platform 412, so that reliable and complete curing takes place particularly in the contact region between the lower side of the production platform 412 and the photopolymerizable material, and therefore good adhesion of the first layer to the production platform 412 is ensured. After the layer has been formed, the production platform is raised again by means of the lifting mechanism.

These steps are subsequently repeated several times, the distance from the lower side of the layer 422 formed last to the tank bottom 406 respectively being set to the desired layer thickness Δ and the next layer thereupon being cured position-selectively in the desired way.

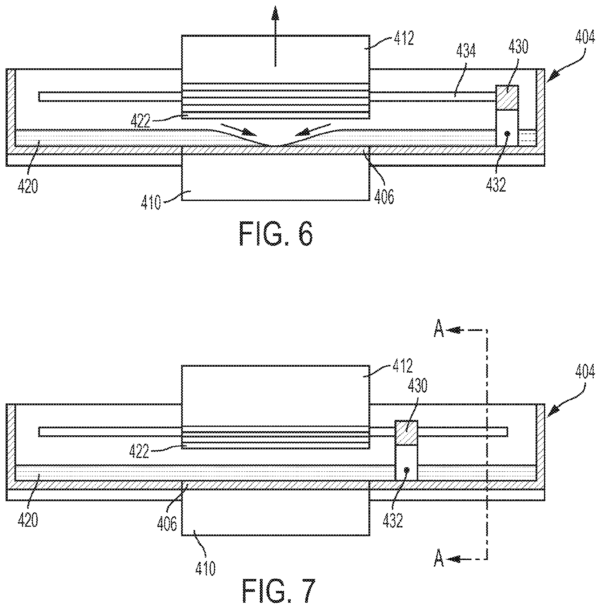

After the production platform 412 has been raised following an exposure step, there is a material deficit in the exposed region as indicated in FIG. 6. This is because after curing the layer set with the thickness Δ, the material of this layer is cured and raised with the production platform and the part of the shaped body already formed thereon. The photopolymerizable material therefore missing between the lower side of the already formed shaped body part and the tank bottom 406 must be filled from the filling of photopolymerizable material 420 from the region surrounding the exposed region. Owing to the high viscosity of the material, however, it does not flow by itself back into the exposed region between the lower side of the shaped body part and the tank bottom, so that material depressions or "holes" can remain here.

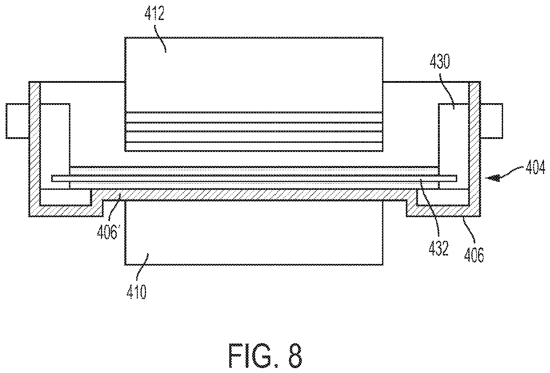

In order to replenish the exposure region with photopolymerizable material, an elongate mixing element 432 is moved through the filling of photopolymerizable material 420 in the tank. In the exemplary embodiment represented in FIGS. 4 to 8, the mixing element 432 comprises an elongate wire which is tensioned between two support arms 430 mounted movably on the side walls of the tank 404. The support arms 430 may be mounted movably in guide slots 434 in the side walls of the tank 404, so that the wire 432 tensioned between the support arms 430 can be moved relative to the tank 404, parallel to the tank bottom 406, by moving the support arms 430 in the guide slots 434. The elongate mixing element 432 has dimensions, and its movement is guided relative to the tank bottom, such that the upper edge of the elongate mixing element 432 remains below the material level of the filling of photopolymerizable material 420 in the tank outside the exposed region. As can be seen in the sectional view of FIG. 8, the mixing element 432 is below the material level in the tank over the entire length of the wire, and only the support arms 430 protrude beyond the material level in the tank. The effect of arranging the elongate mixing element below the material level in the tank 404 is not that the elongate mixing element 432 substantially moves material in front of it during its movement relative to the tank through the exposed region, but rather this material flows over the mixing element 432 while executing a slight upward movement. The movement of the mixing element 432 from the position shown in FIG. 6, to, for example, a new position in the direction indicated by the arrow A, is shown in FIG. 7. It has been found that by this type of action on the photopolymerizable material in the tank, the material is effectively stimulated to flow back into the material-depleted exposed region between the production platform 412 and the exposure unit 410.

The movement of the elongate mixing element 432 relative to the tank may firstly, with a stationary tank 404, be carried out by a linear drive which moves the support arms 430 along the guide slots 434 in order to achieve the desired movement of the elongate mixing element 432 through the exposed region between the production platform 412 and the exposure unit 410. As shown in FIG. 8, the tank bottom 406 has recesses 406' on both sides. The support arms 430 project with their lower ends into these recesses 406'. This makes it possible for the elongate mixing element 432 to be held at the height of the tank bottom 406, without interfering with the movement of the lower ends of the support arms 430 through the tank bottom 406.

Other alternative methods of DLP may be used to prepare the integrated core-shell molds of the present invention. For example, the tank may be positioned on a rotatable platform. When the workpiece is withdrawn from the viscous polymer between successive build steps, the tank may be rotated relative to the platform and light source to provide a fresh layer of viscous polymer in which to dip the build platform for building the successive layers.

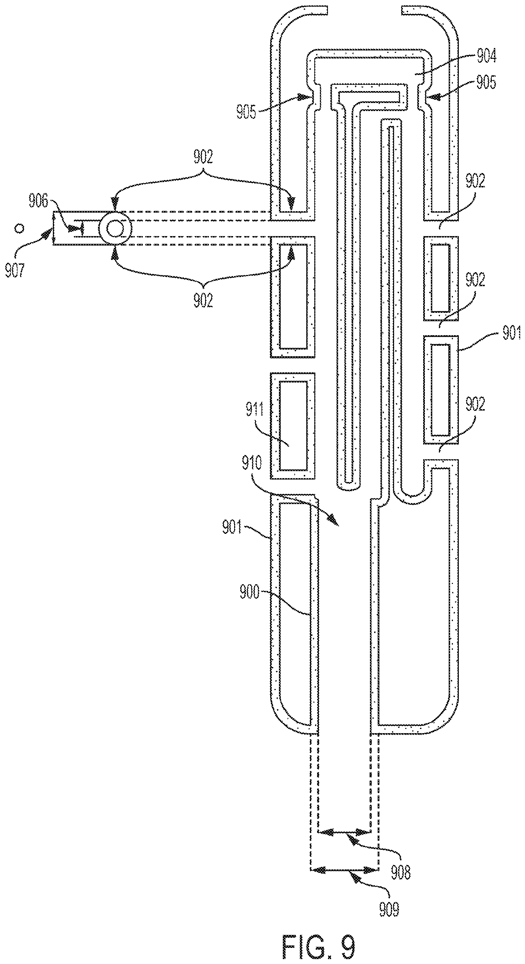

FIG. 9 shows a schematic side view of an integrated core-shell mold with hollow filaments 902 connecting the core 900 and shell portions 901. The hollow filaments generally have an inside diameter 906 and an outside diameter 907. By printing the ceramic mold using the above DLP printing process, the mold can be made in a way that allows the point of connections between the core and shell to be provided through the hollow filaments 902. Once the core-shell mold is printed, it may be subject to a post-heat treatment step to cure the printed ceramic polymer material. The cured ceramic mold may then be used similar to the traditional casting process used in the production of superalloy turbine blades. Notably because the hollow filaments 902 are provided in a large quantity consistent with formation of a pattern of effusion cooling holes in the surface of a turbine blade, the need for a ball chute structure as shown in FIG. 2 may be eliminated. In this embodiment, the hollow tip pins 905 connecting the hollow tip plenum core 904 to the hollow core 900 are retained. After removal of the ceramic mold, tip holes exist between the hollow core 900 and hollow tip plenum core 904 that may be subsequently brazed shut. However, the hollow tip pins 905 may be eliminated by connecting the tip plenum core 904 to the shell 901 using additional hollow filaments, avoiding the need to braze shut tip holes connecting the core cavity with the tip plenum after casting is complete.

The mold core 900 may also be a hollow mold core in accordance with certain aspects of the invention. The hollow core has an inside diameter 908 and an outside diameter 909. In general, the cross sectional area defined by the inner diameter is greater than 80% of the cross sectional area of the outer diameter, preferably greater than 90%. In the case where the mold core does not have a cylindrical shape, the wall thickness of the hollow core is equivalent to that of the cylinder where the inner diameter is greater than 80% of the cross sectional area of the outer diameter.

The filaments 902 are preferably cylindrical or oval shape but may be curved or non-linear. Their exact dimensions may be varied according to a desired film cooling scheme for a particular cast metal part. For example cooling holes may have a cross sectional area ranging from 0.01 to 2 mm². In a turbine blade or stator vane, the cross sectional area may range from 0.01 to 0.15 mm², more preferably from 0.05 to 0.1 mm², and most preferably about 0.07 mm². In the case of a vane, the cooling holes may have a cross sectional area ranging from 0.05 to 0.2 mm², more preferably 0.1 to 0.18 mm², and most preferably about 0.16 mm². The spacing of the cooling holes is typically a multiple of the diameter of the cooling holes ranging from 2× to 10× the diameter of the cooling holes, most preferably about 4-7× the diameter of the holes.

The length of the filament 902 is dictated by the thickness of the cast component, e.g., turbine blade or stator vane wall thickness, and the angle at which the cooling hole is disposed relative to the surface of the cast component. The typical lengths range from 0.5 to 5 mm, more preferably between 0.7 to 1 mm, and most preferably about 0.9 mm. The angle at which a cooling hole is disposed is approximately 5 to 35° relative to the surface, more preferably between 10 to 20°, and most preferably approximately 12°. It should be appreciated that the methods of casting according to the present invention allow for formation of cooling holes having a lower angle relative to the surface of the cast component than currently available using conventional machining techniques.

The cross-sectional area defined by the inner diameter 906 of the hollow filament should be at least 50% of the outer diameter 907 of the filament. For thinner tubes this cross-sectional area can be increased, for example, to 60%, 70%, or 75% of the outer diameter of the filament. In some cases one or more of the filaments connecting the core 900 and the shell 901 of the turbine blade may be solid.

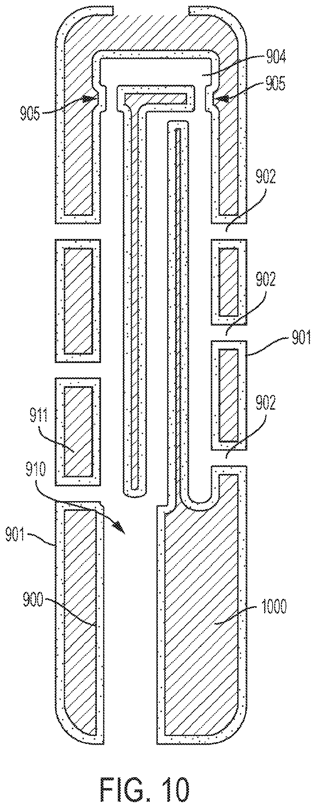

FIG. 10 shows the integrated core-shell mold of FIG. 9 filled with cast metal 1000, such as a nickel based alloy, i.e., Inconel. The metal is filled into cavity 911, while the hollow core cavity 910 is left unfilled. After casting, the ceramic core 900, shell 901 and filaments 902 are removed using a combination of chemical and mechanical processes. The hollow nature of the core 900 and filaments 902 allows for removal of the ceramic mold while minimizing the amount of chemical leaching needed. This saves time and reduces the potential for errors in the manufacturing process.

Upon leaching of the ceramic core-shell, the resulting cast object is a turbine blade having a cooling hole pattern in the surface of the blade. It should be appreciated that although FIGS. 9-10 provide a cross sectional view showing cooling holes at the leading and trailing edge of the turbine blade, that additional cooling holes may be provided where desired including on the sides of the turbine blades or any other location desired. In particular, the present invention may be used to form cooling holes within the casting process in any particular design. In other words, one would be able to produce conventional cooling holes in any pattern where drilling was used previously to form the cooling holes. However, the present invention will allow for cooling hole patterns previously unattainable due to the limitations of conventional technologies for creating cooling holes within cast components, i.e., drilling.

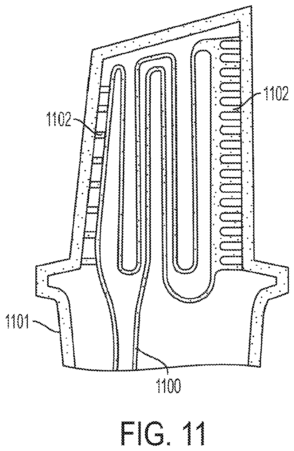

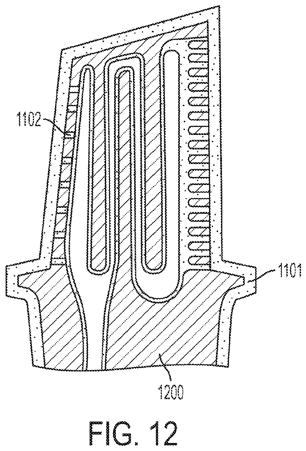

FIG. 11 shows a side view of an integrated core-shell mold according to an embodiment of the present invention. In this embodiment, the mold has a hollow ceramic core 1100 and a ceramic shell 1101. The core 1100 and shell 1101 are connected by filaments 1102. The filaments 1102 are shown as solid filaments that end up resulting in holes in the ultimate case object. The filaments 1102 may be made hollow as described above. Because of the relatively small size of the filaments 1102 relative to the core 1100, the filaments may be made solid and the core hollow as shown in FIG. 11. The hollow core provides a cavity 910 that can subsequently be filled with metal. Because the wall thickness of the hollow core is controlled (as opposed to a solid core), subsequent leaching of the ceramic core can be expedited. As noted above, the filaments 1102 may be solid filaments as shown in FIGS. 11 and 12, or hollow filaments as shown in FIGS. 9-10.

After leaching, the resulting holes in the turbine blade from the core print filaments may be brazed shut if desired. Otherwise the holes left by the core print filaments may be incorporated into the design of the internal cooling passages. Alternatively, cooling hole filaments may be provided to connect the tip plenum core to the shell in a sufficient quantity to hold the tip plenum core in place during the metal casting step.

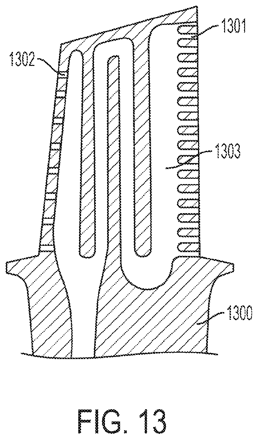

After printing the core-shell casting mold in accordance with the invention, the core-shell mold may be cured and/or fired depending upon the requirements of the ceramic core photopolymer material. Molten metal may be poured into the mold to form a cast object in the shape and having the features provided by the integrated core-shell mold. In the case of a turbine blade or stator vane, the molten metal is preferably a superalloy metal that is formed into a single crystal superalloy turbine blade or stator vane using techniques known to be used with conventional investment casting molds. FIG. 12 shows the ceramic integrated mold 1100/1101 of FIG. 11 filled with cast metal 1200, such as a nickel based alloy, i.e., Inconel. After metal is filled into the mold, the ceramic mold is removed using a combination of mechanical and chemical processes (i.e., leaching). After leaching, the resulting holes in the turbine blade serve as effusion cooling holes. FIG. 13 shows a cast turbine blade 1300 with cooling holes 1301, 1302 connecting the blade surface to the hollow core 1303 of the blade. This written description uses examples to disclose the invention, including the preferred embodiments, and also to enable any person skilled in the art to practice the invention. The patentable scope of the invention is defined by the appended claims.

## Claims

1. A method for fabricating a ceramic casting mold using direct light processing, DLP, comprising:
(a) contacting a cured portion of a workpiece with a liquid ceramic photopolymer;
(b) irradiating a portion of the liquid ceramic photopolymer adjacent to the cured portion through a window contacting the liquid ceramic photopolymer;
(c) removing the workpiece from the uncured liquid ceramic photopolymer; and
(d) repeating steps (a) - (c) until a ceramic casting mold is formed, the ceramic casting mold comprising:
(1) a core portion (1100) and a shell portion (1101) with at least one cavity between the core portion (1100) and the shell portion (1101), the at least one cavity defining the shape of a cast component upon casting and removal of the ceramic casting mold, and
(2) a plurality of filaments (1102) joining the core portion (1100) and the shell portion (1101) where each filament (1102) spans between the core and shell and defines a hole in the cast component upon removal of the mold, wherein at least a portion of the plurality of filaments (1102) and/or the core portion (1100) is in the shape of a hollow tube.

2. The method of any one of claims 1, wherein the outer diameter of the filament (1102) has a cross sectional area ranging from 0.01 to 2 mm².

3. The method of any one of claims 1-2. wherein the filament hollow tube has an inner diameter cross-sectional area that is at least 50% of the cross sectional area of the outer diameter of the filament (1102).

4. The method of any one of claims 1-3, wherein the core hollow tube structure has an inner diameter cross-sectional area that is at least 80% of the cross sectional area of the outer diameter of the core portion (1100).

5. A method of preparing a cast component comprising:
(a) pouring a liquid metal into a ceramic casting mold manufactured in accordance with any of the preceding claims, and solidifying the liquid metal to form the cast component, the ceramic casting mold comprising:
(1) a core portion (1100) and a shell portion (1101) with at least one cavity between the core portion (1100) and the shell portion (1101), the at least one cavity defining the shape of a cast component upon casting and removal of the ceramic casting mold, and
(2) a plurality of filaments (1102) joining the core portion (1100) and the shell portion (1101) where each filament spans between the core and shell and defines a hole in the cast component, wherein at least a portion of the filament (1102) and/or the core portion (1100) is in the shape of a hollow tube;
(b) removing the ceramic casting mold from the cast component by leaching at least a portion of the ceramic core through the holes in the cast component.

## Patentansprüche

1. Verfahren zur Herstellung einer keramischen Gussform unter Verwendung der direkten Lichtverarbeitung, DLP, umfassend:
(a) Inkontaktbringen eines gehärteten Teils eines Werkstücks mit einem flüssigen keramischen Photopolymer;
(b) Bestrahlung eines Teils des flüssigen keramischen Photopolymers, der an den gehärteten Teil angrenzt, durch ein Fenster, das mit dem flüssigen keramischen Photopolymer in Kontakt steht;
(c) Entfernen des Werkstücks aus dem ungehärteten flüssigen keramischen Photopolymer; und
(d) Wiederholen der Schritte (a) - (c), bis eine keramische Gussform gebildet ist, wobei die keramische Gussform umfasst:
(1) einen Kernabschnitt (1100) und einen Schalenabschnitt (1101) mit mindestens einem Hohlraum zwischen dem Kernabschnitt (1100) und dem Schalenabschnitt (1101), wobei der mindestens eine Hohlraum die Form eines gegossenen Bauteils beim Gießen und Entfernen der keramischen Gießform definiert, und
(2) eine Vielzahl von Filamenten (1102), die den Kernabschnitt (1100) und den Schalenabschnitt (1101) verbinden, wobei jedes Filament (1102) sich zwischen dem Kern und der Schale erstreckt und ein Loch in der Gusskomponente beim Entfernen der Form definiert, wobei mindestens ein Teil der Vielzahl von Filamenten (1102) und/oder der Kernabschnitt (1100) die Form eines hohlen Rohrs aufweist.

2. Verfahren nach einem der Ansprüche 1, wobei der Außendurchmesser des Filaments (1102) eine Querschnittsfläche im Bereich von 0,01 bis 2 mm2 aufweist.

3. Verfahren nach einem der Ansprüche 1 bis 2, wobei das hohle Filamentrohr eine Querschnittsfläche des Innendurchmessers aufweist, die mindestens 50 % der Querschnittsfläche des Außendurchmessers des Filaments (1102) beträgt.

4. Verfahren nach einem der Ansprüche 1-3, wobei die Kernhohlrohrstruktur eine Querschnittsfläche des Innendurchmessers aufweist, die mindestens 80 % der Querschnittsfläche des Außendurchmessers des Kernteils (1100) beträgt.

5. Verfahren zur Herstellung eines Gußteils, umfassend:
(a) Gießen eines flüssigen Metalls in eine nach einem der vorhergehenden Ansprüche hergestellte keramische Gießform und Verfestigen des flüssigen Metalls, um das Gussbauteil zu bilden, wobei die keramische Gießform umfasst:
(1) einen Kernabschnitt (1100) und einen Schalenabschnitt (1101) mit mindestens einem Hohlraum zwischen dem Kernabschnitt (1100) und dem Schalenabschnitt (1101), wobei der mindestens eine Hohlraum die Form eines gegossenen Bauteils beim Gießen und Entfernen der keramischen Gießform definiert, und
(2) eine Vielzahl von Filamenten (1102), die den Kernabschnitt (1100) und den Schalenabschnitt (1101) verbinden, wobei sich jeder Faden zwischen dem Kern und der Schale erstreckt und ein Loch in der Gusskomponente definiert, wobei mindestens ein Teil des Filaments (1102) und/oder des Kernabschnitts (1100) die Form eines hohlen Rohrs aufweist;
(b) Entfernen der keramischen Gießform von der Gusskomponente durch Auslaugen mindestens eines Teils des Keramikkerns durch die Löcher in der Gusskomponente.

## Revendications

1. Un procédé de fabrication d'un moule de coulée en céramique utilisant le traitement par lumière directe, DLP, comprenant :
(a) la mise en contact d'une partie durcie d'une pièce avec un photopolymère céramique liquide;
(b) l'irradiation d'une partie du photopolymère céramique liquide adjacente à la partie durcie à travers une fenêtre en contact avec le photopolymère céramique liquide;
(c) retirer la pièce du photopolymère céramique liquide non durci ; et
(d) répéter les étapes (a) - (c) jusqu'à ce qu'un moule de coulée en céramique soit formé, le moule de coulée en céramique comprenant :
(1) une partie de noyau (1100) et une partie de coquille (1101) avec au moins une cavité entre la partie de noyau (1100) et la partie de coquille (1101), la au moins une cavité définissant la forme d'un composant coulé lors du coulage et du retrait du moule de coulage en céramique, et
(2) une pluralité de filaments (1102) joignant la partie noyau (1100) et la partie coquille (1101) où chaque filament (1102) s'étend entre le noyau et la coquille et définit un trou dans le composant coulé lors du retrait du moule, dans lequel au moins une partie de la pluralité de filaments (1102) et/ou la partie noyau (1100) a la forme d'un tube creux.

2. Le procédé de l'une quelconque des revendications 1, dans lequel le diamètre extérieur du filament (1102) a une surface de section transversale allant de 0,01 à 2 mm2.

3. Le procédé de l'une quelconque des revendications 1 à 2, dans lequel le tube creux du filament présente une surface de section transversale du diamètre intérieur qui est au moins égale à 50% de la surface de section transversale du diamètre extérieur du filament (1102).

4. Le procédé de l'une quelconque des revendications 1 à 3, dans lequel la structure de tube creux de noyau a une aire de section transversale de diamètre interne qui est au moins 80 % de l'aire de section transversale du diamètre externe de la partie de noyau (1100).

5. Le procédé de préparation d'un composant coulé comprenant les étapes consistant à :
(a) le versement d'un métal liquide dans un moule de coulée en céramique fabriqué selon l'une quelconque des revendications précédentes, et la solidification du métal liquide pour former le composant coulé, le moule de coulée en céramique comprenant :
(1) une partie noyau (1100) et une partie coquille (1101) avec au moins une cavité entre la partie noyau (1100) et la partie coquille (1101), la au moins une cavité définissant la forme d'un composant coulé lors de la coulée et du retrait du moule de coulée en céramique, et
(2) une pluralité de filaments (1102) joignant la partie de noyau (1100) et la partie de coquille (1101) où chaque filament s'étend entre le noyau et la coquille et définit un trou dans le composant coulé, dans lequel au moins une partie du filament (1102) et/ou de la partie de noyau (1100) a la forme d'un tube creux ;
(b) retirer le moule de coulée en céramique du composant coulé en lessivant au moins une partie du noyau en céramique à travers les trous dans le composant coulé.
